# EUROPEAN PATENT APPLICATION

(11) **EP 2 506 697 A2**
(43) Date of publication of application: **03.10.2012**
(21) Application number: 12153984.5
(22) Date of filing: 06.02.2012
(51) Int. Cl.: H05K 7/20

(54) **Server device, control device, server rack, recording medium storing cooling control program, and cooling control method**

(30) Priority: 30.03.2011 JP 2011076453
(71) Applicant: Fujitsu Limited, Kawasaki-shi, Kanagawa 211-8588 (JP); Fujitsu Technology Solutions Intellectual Property GmbH, 80807 München (DE)
(72) Inventor: Kobayashi, Hiroki, Kawasaki-shi, Kanagawa 211-8588 (JP); Scheidler, Gerold, 80807 München (DE); Nguyen, Van Son, 80807 München (DE); Poskitt, Geoff, 80807 München (DE); Sato, Yuichi, Kawasaki-shi, Kanagawa 211-8588 (JP); Kimura, Takahiro, Kawasaki-shi, Kanagawa 211-8588 (JP); Taniguchi, Jun, Kawasaki-shi, Kanagawa 211-8588 (JP); Hibino, Seiji, Kawasaki-shi, Kanagawa 211-8588 (JP); Sugimoto, Toshio, Kawasaki-shi, Kanagawa 211-8588 (JP); Umezawa, Yasushi, Kawasaki-shi, Kanagawa 211-8588 (JP); Kondo, Reiko, Kawasaki-shi, Kanagawa 211-8588 (JP); Schräder, Bernhard, 80807 München (DE)
(74) Representative: Lewin, David Nicholas

(57) **Abstract**

A server device includes: electronic devices; a housing that houses the electronic devices; at least one fan; air volume control units configured to adjust a volume of cooling airflow which is generated by rotation of the at least one fan and is ventilated through the electronic devices by opening and closing of respective valves; a valve opening control unit configured to control valve opening degrees of the air volume control units so that temperatures inside the electronic devices become a given target temperature; a fan control unit configured to run the at least one fan at a fan rotating speed that achieves a volume of cooling airflow to make temperatures inside the electronic devices become the given target temperature at a valve opening degree higher than the valve opening degrees that the valve opening control unit controls.

## Description

### FIELD

The present invention relates to cooling a server device.

### BACKGROUND

Recently, a blade server which has advantages in high integration and scalability has been focused as an electronic apparatus such as a server computer. A plurality of components called as blades are located in the inside of a housing (a server rack) of the blade server. Each blade component has a substrate on which necessary elements for a computer such as a CPU (Central Processing Unit), a memory and an HDD (Hard Disk Drive) are packaged.

Each element such as a CPU or an HDD, which is mounted on the substrate of each blade, produces heat when operating. When the temperature inside the blade of the blade server becomes too high because of the heat from each element, a thermal runaway may occur in the CPU or another element. Therefore, various methods for cooling blades or a server device have been proposed, as disclosed in Japanese Patent Application Publication Nos. 2009-231493, 11-204974 and 06-348369 (Documents 1 through 3).

### SUMMARY

It is an object of the present invention to reduce power consumption in cooling a server device.

According to an aspect of the present invention, there is provided a server device including: electronic devices; a housing that houses the electronic devices; at least one fan; air volume control units configured to adjust a volume of cooling airflow which is generated by rotation of the at least one fan and is ventilated through the electronic devices by opening and closing of respective valves; a valve opening control unit configured to control valve opening degrees of the air volume control units so that temperatures inside the electronic devices become a given target temperature; a fan control unit configured to run the at least one fan at a fan rotating speed that achieves a volume of cooling airflow to make temperatures inside the electronic devices become the given target temperature at a valve opening degree higher than the valve opening degrees that the valve opening control unit controls.

The object and advantages of the invention will be realized and attained by means of the elements and combinations particularly pointed out in the claims.

It is to be understood that both the foregoing general description and the following detailed description are and explanatory and are not restrictive of the invention, as claimed.

### BRIEF DESCRIPTION OF DRAWINGS

FIG. 1 is a diagram illustrating a composition of a server device in accordance with a first embodiment;
FIG. 2 is a diagram illustrating a composition of a server;
FIGs. 3A and 3B are diagrams illustrating a composition of an air volume control unit;
FIG. 4 is a diagram illustrating a hardware structure of a control device in accordance with the first embodiment;
FIG. 5 is a functional block diagram illustrating functions that the control device in accordance with the first embodiment has;
FIG. 6 is a flowchart illustrating a process executed by the control device in accordance with the first embodiment;
FIG. 7 is a control block diagram illustrating a control executed by the control device in accordance with the first embodiment;
FIG. 8 is a control block diagram of a control system where a control of air volume control units and a control of a fan are executed independently;
FIG. 9 is a diagram illustrating volume-pressure characteristics of the fan;
FIG. 10 is a diagram illustrating a composition of a server device in accordance with a first comparative example;
FIG. 11 illustrates a mathematical model of a server used for a simulation;
FIG. 12 illustrates a mathematical model of a server rack used for a simulation;
FIG. 13 is a diagram illustrating simulation results of power consumption for cooling server devices in accordance with first and second comparative examples and the first embodiment;
FIG. 14 is a diagram illustrating another composition of the server device in accordance with the first embodiment;
FIG. 15 is another example of a functional block diagram of the server device in accordance with the first embodiment;
FIGs. 16A and 16B illustrate a method with which a valve opening control unit calculates a valve opening degree of an air volume control unit from a stack pressure, an external temperature and a power consumption of a server;
FIG. 17 is a diagram illustrating a composition of a server device in accordance with a first variant embodiment;
FIG. 18 is a functional block diagram illustrating functions that a control device in accordance with the first variant embodiment has;
FIG. 19 is a diagram illustrating a composition of a server device in accordance with a second variant embodiment;
FIG. 20 is a flowchart illustrating a process executed by a load adjusting unit in accordance with the second variant embodiment;
FIG. 21 is a flowchart illustrating a process executed by a valve opening control unit and a fan control unit in accordance with the second variant embodiment;
FIG. 22 is a diagram illustrating a composition of the server in accordance with a third variant embodiment;
FIGs. 23A and 23B illustrate simulation results of power consumption for cooling server devices in accordance with first and second comparative examples and first through third variant embodiments;
FIGS. 24A and 24B illustrate simulation results of power consumption for cooling a server device when a server of which the load becomes 0% is powered off;
FIG. 25 is a control block diagram illustrating another example of a control executed by control devices in accordance with the first embodiment and first through third variant embodiments; and
FIGs. 26A and 26B are diagrams illustrating a composition of a system for cooling the server device.

### DESCRIPTION OF EMBODIMENTS

As described previously, various methods for cooling blades or a server device have been suggested.

Recently, as the number of the server device increases, the reduction of power consumption for cooling them becomes issues in a data center or the like. As response to environmental issues, the reduction of power consumption of the server device is desired. However, techniques disclosed in Documents 1 through 3 have a possibility to waste electricity for cooling the server device.

A description will now be given of embodiments of the present invention with reference to the accompanying drawings.

### [First Embodiment]

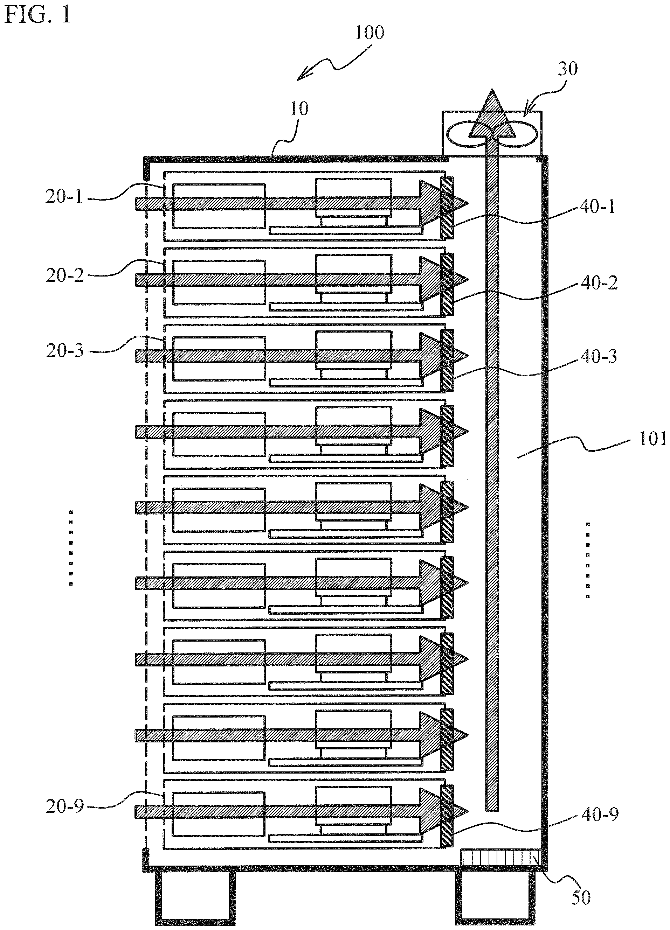

FIG 1 is a diagram illustrating a composition of a server device in accordance with a first embodiment. A server device 100 includes a server rack (a housing)10, servers (a plurality of electronic devices) 20-1 through 20-9, a fan 30, air volume control units 40-1 through 40-9, and a control device 50.

The server rack 10 houses servers 20-1 through 20-9. A stack 141, which is a path of cooling airflow that passes through servers 20-1 through 20-9, is provided to the server rack 10. In the present embodiment, the server rack 10 houses nine servers. However, the number of servers housed in the server rack 10 is not limited to the above. Hereinafter, servers 20-1 through 20-9 are described as servers 20 except a case where each server should be distinguished from others.

The fan 30 ejects air inside the server rack 10 or inducts air to the inside of the server rack 10 by rotating. The fan 30 generates the cooling airflow passing through servers 20-1 through 20-9 by the ejection or induction of air. In the present embodiment, the cooling airflow is generated by the ejection of air inside the server rack 10 by the fan 30. In FIG. 1, the cooling airflow generated by the rotation of the fan 30 is illustrated with arrows. In the present embodiment, the number of the fan 30 provided to the server device 100 is one. However, the number of the fan 30 provided to the server device 100 may be equal to or more than two.

Air volume control units 40-1 through 40-9 control the volume of the cooling airflow passing through servers 20-1 through 20-9. In the present embodiment, air volume control units 40-1 through 40-9 are provided to servers 20-1 through 20-9 respectively. Hereinafter, air volume control units 40-1 through 40-9 are described as air volume control units 40 except when each air volume control unit needs to be distinguished from others.

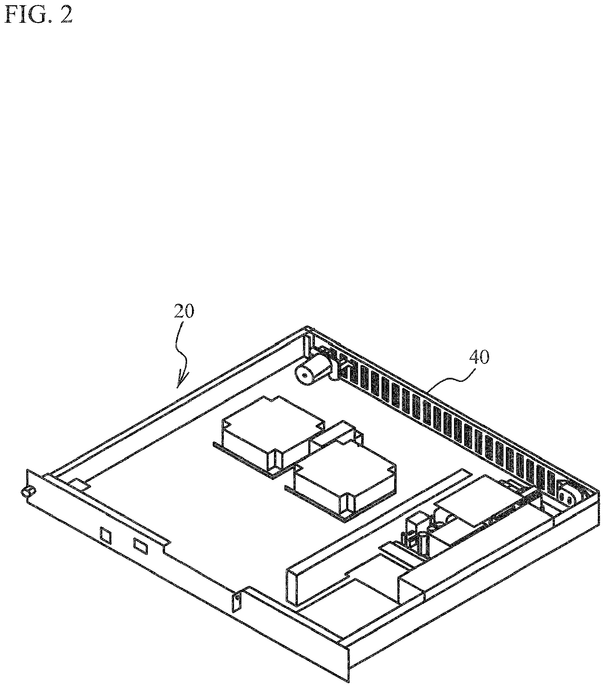

Air volume control units 40 may be provided to servers 20 or the server rack 10. In the present embodiment, air volume control units 40 are provided to their respective servers 20 as illustrated in FIG. 2.

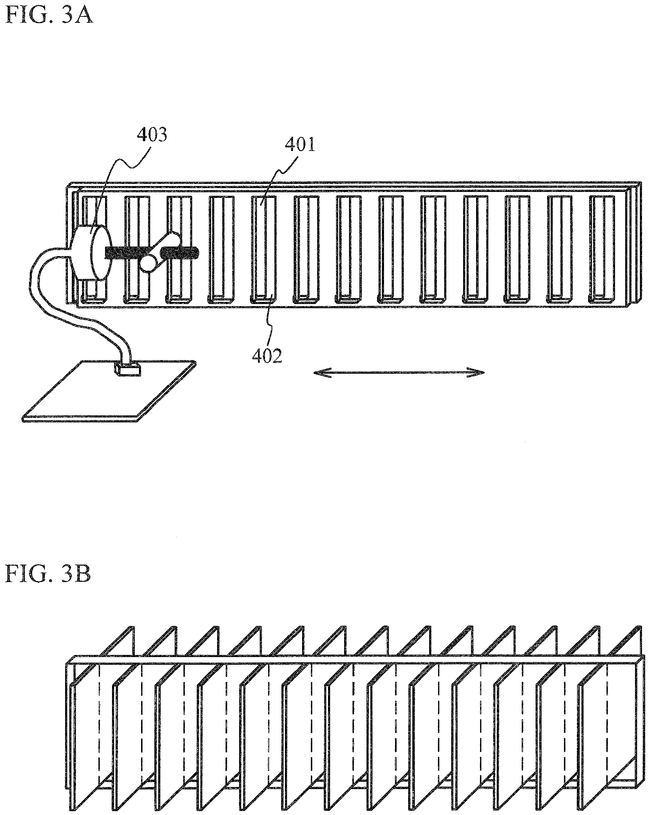

FIG. 3 is a diagram illustrating a structure of each of air volume control units 40. As illustrated in FIG. 3A, each of air volume control units 40 is provided with an outlet (inlet) 401, a shutter 402 and a drive mechanism 403. Air volume control units 40 control their valve opening degrees by moving the shutter 402 with the drive mechanism 403 to horizontal direction (direction of arrow in FIG. 3A), and control the volume of the cooling airflow passing through the outlet 401. In the description hereinafter, the valve opening degree 0% means the state that the outlet 401 is completely closed by the shutter 402, and the valve opening degree 100% means the state that the outlet 401 is completely opened. The structure of air volume control units 40 is not limited to that illustrated in FIG. 3A. For example, as illustrated in FIG. 3B, the structure where the volume of airflow is controlled by changing the direction of multiple louver boards may be possible.

The control device 50 controls the rotating speed of the fan 30 and the valve opening degrees of air volume control units 40 so that temperatures inside servers 20 become a target temperature.

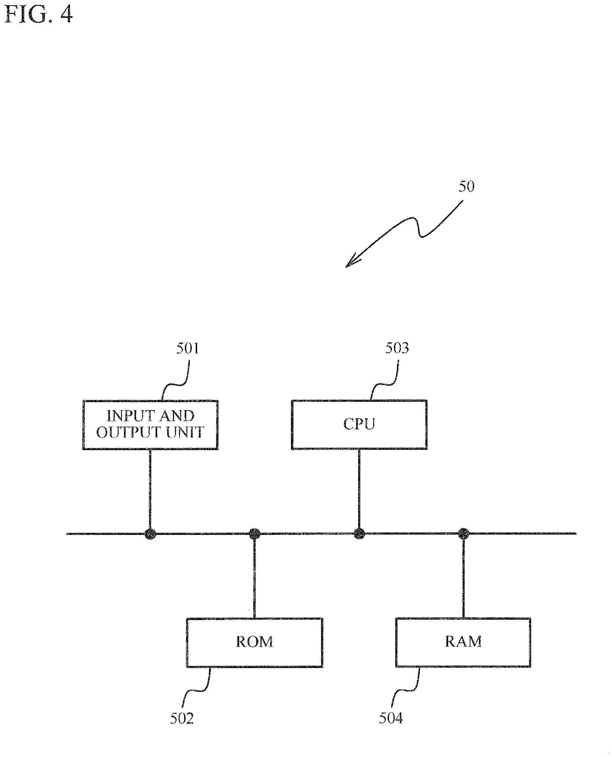

A description will now be given of a hardware structure of the control device 50 with reference to FIG. 4. The control device 50 includes an input and output unit 501, a ROM (Read Only Memory) 502, a CPU 503 and a RAM (Random Access Memory) 504.

The input and output unit 501 inputs and outputs data and control signals to and from servers 20-1 through 20-9, the air volume control units 40-1 through 40-9 and the fan 30. The ROM 502 stores programs for calculating valve opening degrees of air volume control units 40 and the rotating speed of the fan 30 to make temperatures inside servers 20 become a target temperature. The CPU 503 reads and executes programs stored in the ROM 502. The RAM 504 stores temporary data used during the program execution.

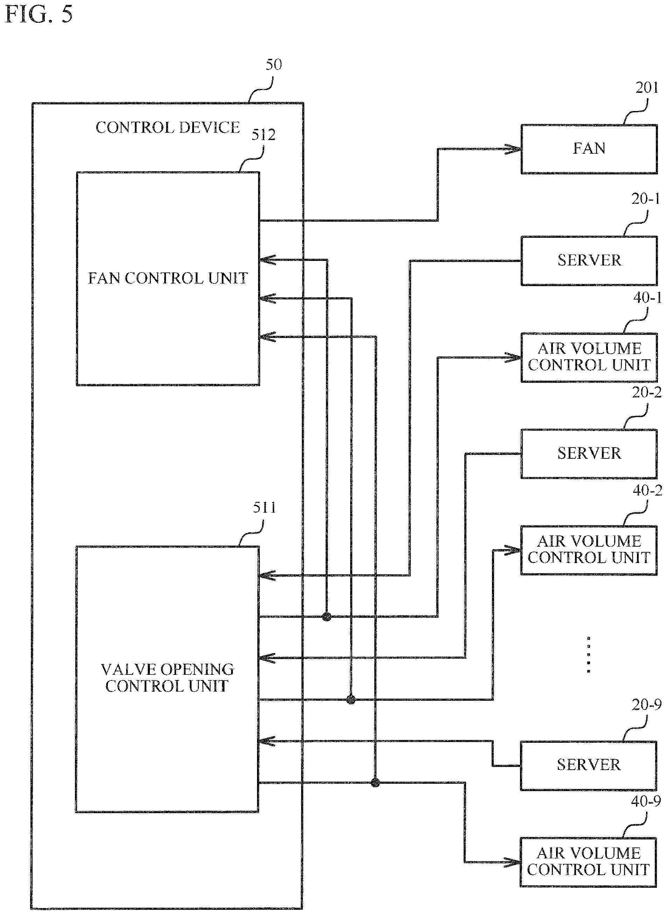

A description will now be given of examples of functions of the control device 50 achieved by the execution of programs stored in the ROM 502 by the CPU 503. FIG. 5 is a functional block diagram illustrating functions that the control device 50 has. As illustrated in FIG. 5, the control device 50 includes a valve opening control unit 511 and a fan control unit 512.

The valve opening control unit 511 obtains temperatures inside servers from servers 20-1 through 20-9. The valve opening control unit 511 may obtain a temperature inside the server from a temperature sensor provided to the CPU in the server, for example. The valve opening control unit 511 may obtain a temperature inside the server from a software, which is installed in the server, for measuring temperature, for example.

The valve opening control unit 511 calculates valve opening degrees of air volume control units 40-1 through 40-9 to make temperatures inside servers become a target temperature. The valve opening control unit 511 controls air volume control units 40-1 through 40-9 so that valve opening degrees of air volume control units 40-1 through 40-9 become calculated valve opening degrees.

The fan control unit 512 obtains valve opening degrees of the air volume control unit 40-1 through 40-9 that the valve opening control unit 511 calculated. The fan control unit 512 calculates a fan rotating speed to make the highest (most opened) valve opening degree of obtained valve opening degrees become a given target opening degree. In the present embodiment, the target opening degree is 100%. The fan control unit 512 controls the fan to rotate at the calculated rotating speed.

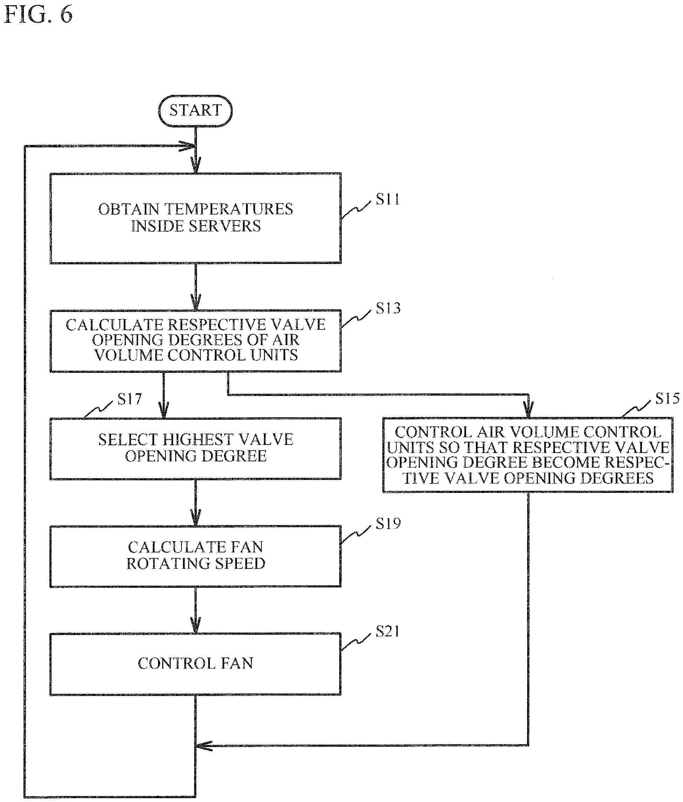

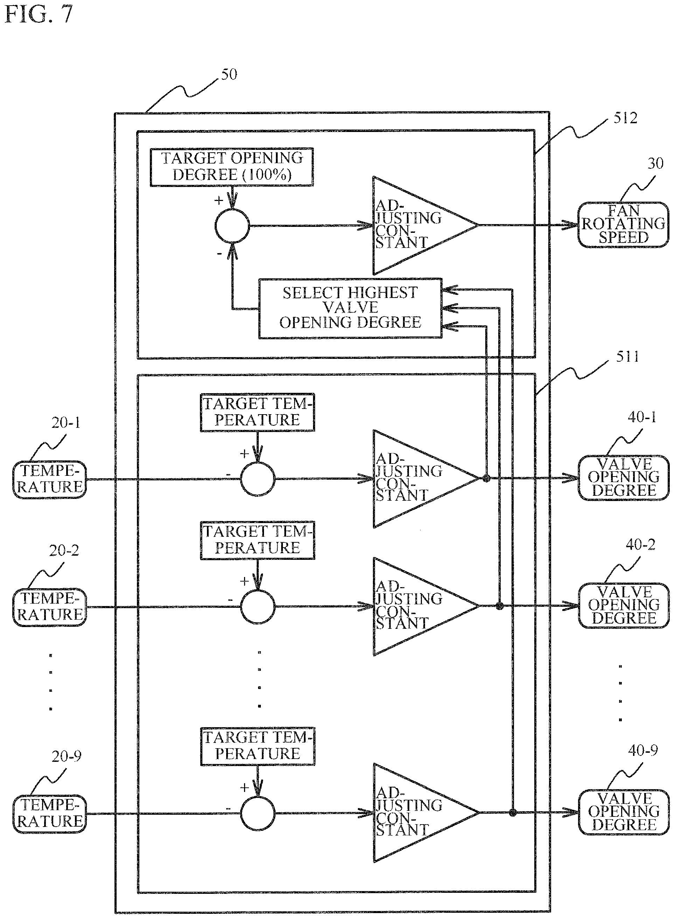

A description will now be given of an example of a process executed by the control device in accordance with the first embodiment. FIG. 6 is a flowchart illustrating a process executed by the control device 50. FIG. 7 illustrates a control block diagram of the control device 50.

The valve opening control unit 511 obtains temperatures inside servers (step S11). Then, the valve opening control unit 511 calculates valve opening degrees of air volume control units 40 on the basis of the temperature information obtained in the step S11 (step S13). More specifically, as illustrated in FIG. 7, the valve opening control unit 511 calculates temperature differences between temperatures inside servers obtained from servers 20-1 through 20-9 and the target temperature. The valve opening control unit 511 calculates valve opening degrees of air volume control units 40-1 through 40-9 by multiplying calculated temperature differences by an adjusting constant for calculating a valve opening degree. The adjusting constant for calculating a valve opening degree is preliminarily calculated by a simulation, an experiment or the like.

The valve opening control unit 511 controls air volume control units 40 so that valve opening degrees become valve opening degrees calculated in the step S13 (step S15).

On the other hand, the fan control unit 512 selects the highest valve opening degree of valve opening degrees of air volume control units 40 calculated by the valve opening control unit 511 (step S17). The fan control unit 512 calculates the fan rotating speed necessary for making the highest valve opening degree become a target opening degree (step S19). More specifically, as illustrated in FIG. 7, the fan control unit 512 calculates the difference between the highest (most opened) valve opening degree of valve opening degrees calculated by the valve opening control unit 511 and the target opening degree (100%). The fan control unit 512 calculates the fan rotating speed by multiplying the calculated difference between the highest valve opening and the target opening degree by an adjusting constant for calculating a rotating speed. The adjusting constant for calculating a rotating speed is preliminarily calculated by a simulation, an experiment or the like.

As seen in the above description, the control system in accordance with the present embodiment is a control system where the control of valve opening degrees of air volume control units 40 and the control of the rotating speed of the fan 30 are related (not executed independently from each other).

The fan control unit 512 controls the fan to rotate at the calculated rotating speed (step S21).

The valve opening control unit 511 and the fan control unit 512 repeat procedures of steps S11 through S21 described above.

A description will now be given of a principle that the power consumption for cooling the server device 100 is reduced by using a control system illustrated in FIG. 7. Here, a control system where the control of air volume control units 40 and the control of the fan 30 are performed independently is used as a comparative example.

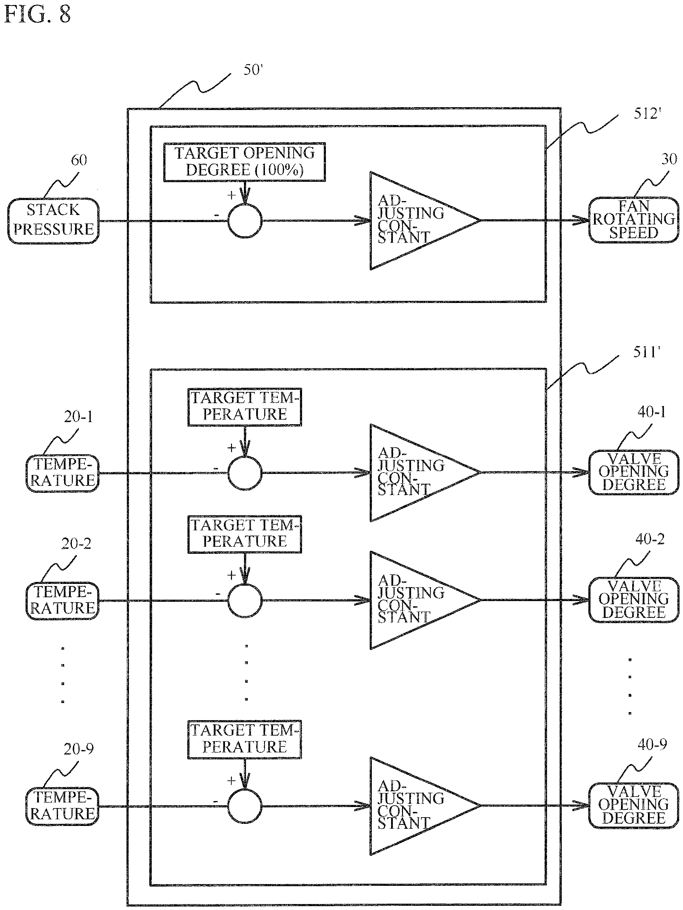

FIG. 8 illustrates a control block diagram of a control system where the control of air volume control units 40 and the control of the fan 30 are performed independently. The control system in FIG. 8 is different from the control system in FIG. 7 in that the fan rotating speed is calculated on the basis of the difference between the pressure inside the stack 101 (stack pressure) and a target pressure. This means that in the control system in accordance with the comparative example, the valve opening degree calculated by the valve opening control unit 511' is not used for the control of the fan rotating speed.

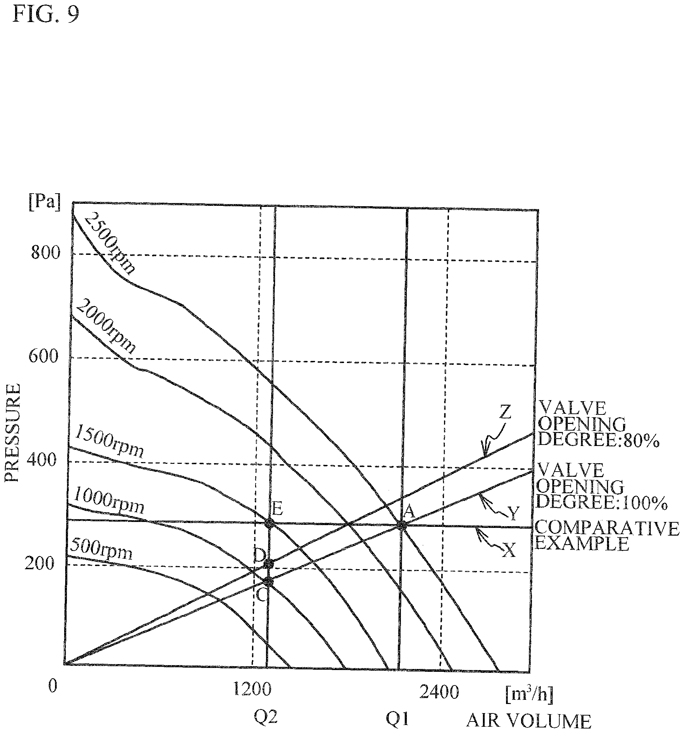

FIG. 9 is a diagram illustrating volume-pressure characteristics of the fan 30. As illustrated in FIG. 9, there is a specific relation between an air volume and a pressure with respect to each fan rotating speed. In FIG. 9, volume-pressure characteristics of the control system in accordance with the comparative example where the stack pressure is constant (the control system in FIG. 8) is indicated by a line X. The volume-pressure characteristics in a case where the valve opening degree of the air volume control unit 40 is 100% in the control system in accordance with the present embodiment (the control system FIG. 8) is indicated by a line Y.

Assume that the cooling airflow with a volume of Q1 is necessary to make temperatures inside servers become a target temperature when the respective loads of servers 20-1 through 20-9 are 100%. In this case, the intersection of Q1 with the line X, and the intersection of Q1 and the line Y are a point A. This means that the fan rotating speed to make temperatures inside servers become a target temperature is the rotating speed indicated by volume-pressure characteristics passing through the intersection point A (2500 [rpm]) in the control system in accordance with the comparative example and the control system in accordance with the present embodiment.

Then, assume that the cooling airflow with a volume of Q2 is necessary to make temperatures inside servers become a target temperature when loads of servers 20-1 through 20-9 are 50%. In this case, in the control system in accordance with the comparative example, the intersection of Q2 with the line X is a point E. This means that when loads of servers 20 are 50%, the fan rotating speed to make temperatures inside servers become a target temperature is the rotating speed indicated by volume-pressure characteristics passing through the intersection point E (1500 [rpm]) in the control system in accordance with the comparative example. On the other hand, in the control system in accordance with the present embodiment, the intersection of Q2 with the line Y is a point C. This means that the fan rotating speed to make temperatures inside servers become a target temperature is the rotating speed indicated by volume-pressure characteristics passing through the intersection point C (1000 [rpm]).

Generally, the power consumption of the fan is proportional to the fan rotating speed. Thus, when loads of servers 20 are lower than 100%, the control system in accordance with the present embodiment may reduce the power consumption compared to the control system in accordance with the comparative example.

In the control system in accordance with the present embodiment, assume that the volume-pressure characteristics when valve opening degrees of air volume control units 40 are 80% is indicated by the line Z. When loads of servers 20 are 50%, the control system in accordance with the present embodiment may make the fan rotating speed lower than the control system in accordance with the comparative example even though the valve opening degree is 80% (the intersection point D). However, as seen in FIG. 9, the fan rotating speed becomes lower in a case where the valve opening degree is 100% (the intersection point C) than that in a case where the valve opening degree is 80%. Thus, assume that the valve opening control unit 511 calculates 80% as the valve opening degree to make temperatures inside servers 20 become a target temperature. In this case, the fan control unit 512 calculates the fan rotating speed which achieves the volume (Q2) of the cooling airflow to make temperatures inside servers become a target temperature at the valve opening degree (for example 100%) which is higher than the valve opening degree 80% which is controlled by the valve opening control unit 511. It becomes possible to reduce the power consumption for cooling the server device 100 by running the fan 30 at the rotating speed (1000 [rpm]) calculated with the above method by the fan control unit 512.

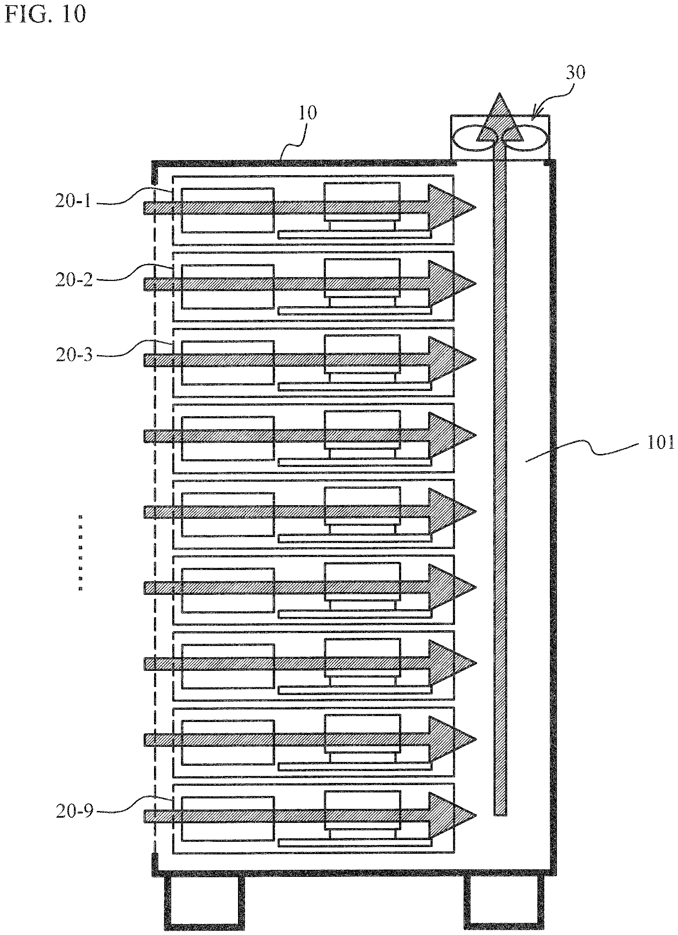

Now a description will be given of the power consumption necessary for cooling the server device in accordance with the first embodiment. Here, a server device that does not include air volume control units 40 but includes only the fan 30 as illustrated in FIG. 10 is referred to as the first comparative example. The server device that includes air volume control units 40 and the fan 30, and where the control of air volume control units 40 and the control of the fan 30 are performed independently as illustrated in FIG. 8 is the second comparative example.

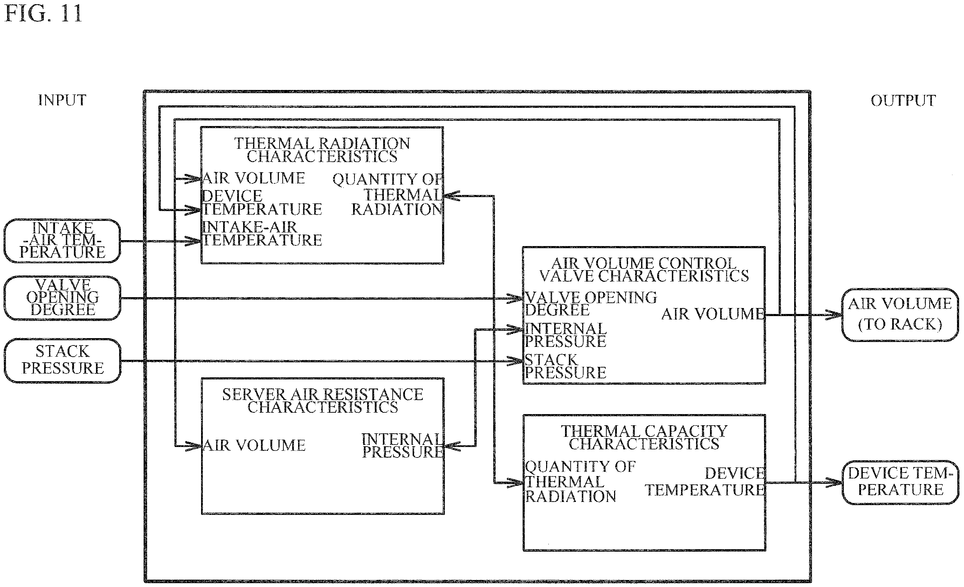

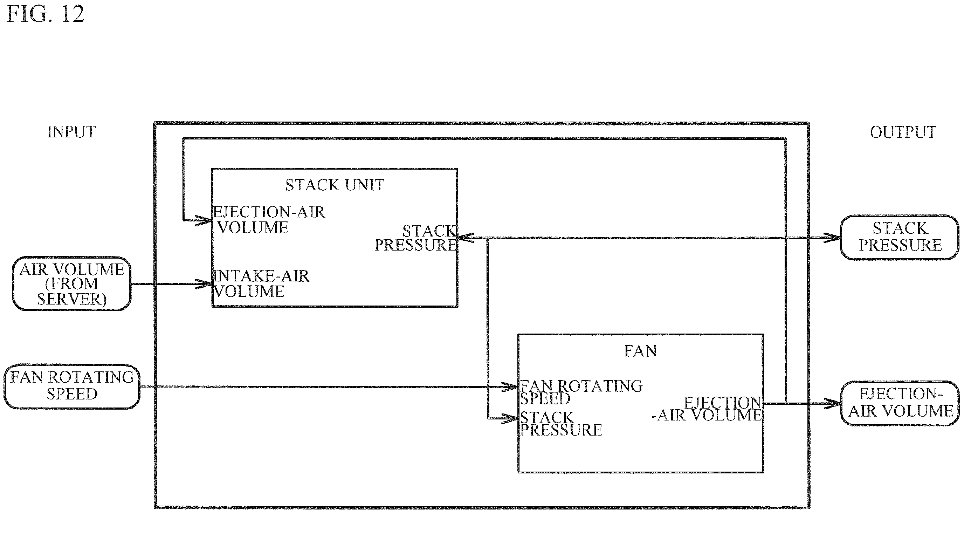

Power consumptions for cooling server devices in accordance with the first comparative example, the second comparative example and the first embodiment are calculated by a simulation. The simulation is conducted by using a mathematical model illustrated in FIG. 11 for the server 20, and a mathematical model illustrated in FIG. 12 for the server rack 10. The simulation is conducted under the assumption that the average load of servers 20-1 through 20-9 is 30%.

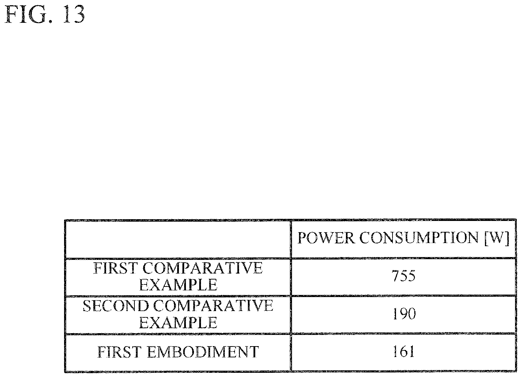

Results of simulations conducted under the above conditions are indicated in FIG. 13. As seen in FIG. 13, the power consumption for cooling the server device in accordance with the first embodiment is equal to about 25 percent of the power consumption of the first comparative example. In addition, the power consumption for cooling the server device in accordance with the first embodiment is equal to about 85 percent of the power consumption of the second comparative example.

As described above, according to the first embodiment, in the server device 100, the valve opening control unit 511 controls valve opening degrees of air volume control units 40-1 through 40-9 so that temperatures inside servers 20-1 through 20-9 become a target temperature. The fan control unit 512 makes the fan 30 rotate at the fan rotating speed that achieves the volume of cooling airflow to make temperatures inside servers 20 become the target temperature at the valve opening degree higher than valve opening degrees controlled by the valve opening control unit 511. Accordingly, as illustrated FIG. 9, as the fan rotating speed is minimized, it becomes possible to reduce the power consumption for cooling the server device 100. According to the server device in accordance with the present embodiment, the power consumption for cooling may be reduced by about 15 percent, as compared to the server device where the control of air volume control units 40 and the control of the fan 30 are performed independently.

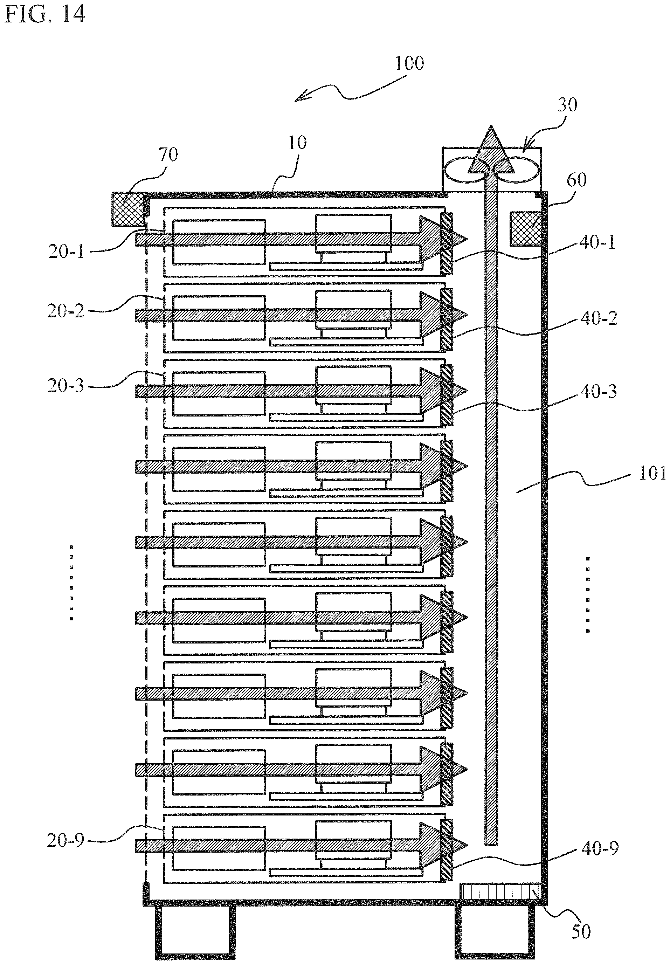

In the above description, the temperature inside the server is obtained by the temperature sensor provided to the CPU, or the measurement software. However, depending on the structure of servers 20, it is difficult to obtain the temperature. In such case, the valve opening degree may be calculated by using the pressure inside the stack 101 (stack pressure), the external temperature of the server rack 10 and power consumption of each of servers. The server device 100 may be provided with a pressure indicator 60 that measures a pressure inside the stack 101 and is located in the stack 101, and an external temperature indicator 70 that measures the external temperature of the server rack 10 in addition to elements described in FIG. 1 (FIG. 14).

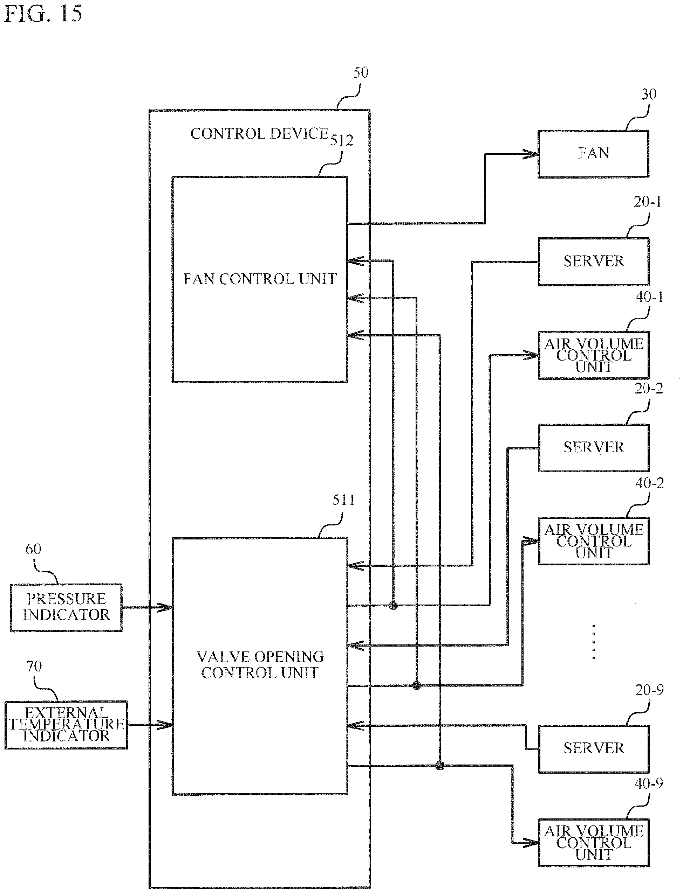

FIG. 15 illustrates another example of a functional block diagram of the control device 50. The valve opening control unit 511 obtains a stack pressure from the pressure indicator 60, an external temperature from the external temperature indicator 70 and power consumptions from each of servers 20. Power consumption of each of servers 20 may be obtained by measuring a power profile of the power source provided to each of servers 20. The power consumption may be calculated by measuring the calculation load of the CPU with the measurement software installed in the server and using the calculation formula representing the relation between the calculation load and the power consumption.

The valve opening control unit 511 calculates valve opening degrees to make temperatures inside servers become the target temperature from the stack pressure, the external temperature and power consumption of each of servers. The valve opening degree may be calculated by constructing a hypothetical feedback control system with a mathematical model and assigning the stack pressure, the external temperature and the power consumption to the constructed mathematical model. Alternatively, the valve opening degree may be calculated by creating a table indicating a relation between the power consumption and the stack pressure and the temperature by the simulation or the experiment, and referring to the created table. It is possible to use the combination of both methods described above.

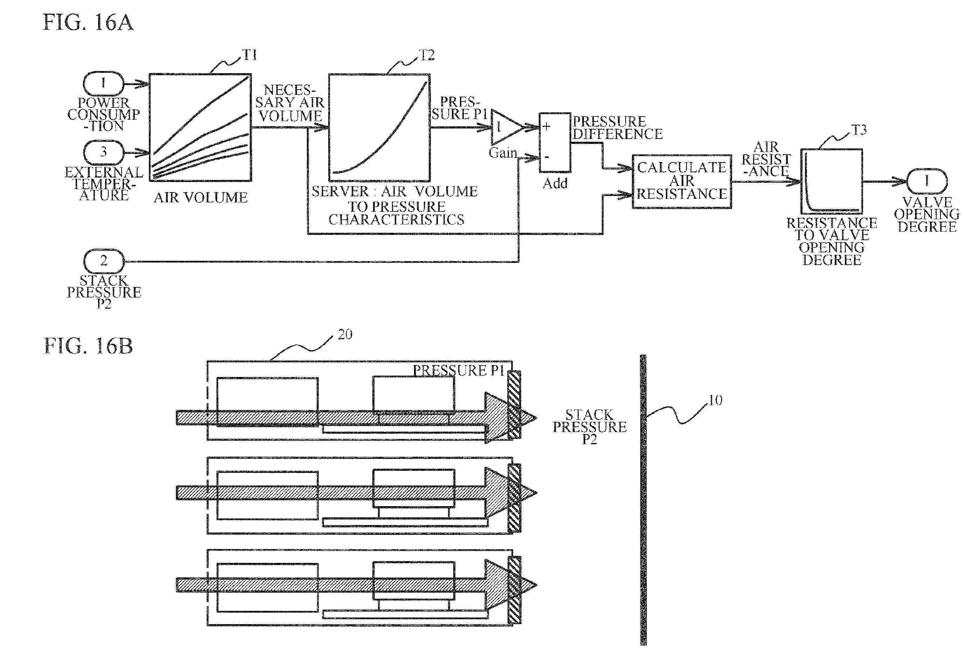

FIGs. 16A and 16B illustrate a method that the valve opening control unit 511 calculates valve opening degrees of air volume control units 40 from the stack pressure, the external temperature and power consumption of each of servers.

In FIG. 16A, the valve opening control unit 511 refers to a two-dimensional table T1, calculates the air volume necessary for cooling from the obtained power consumption and external temperature. The two dimensional table T1 indicates a relation between the power consumption and the external temperature and the air volume necessary to make the temperature inside the server become a target temperature.

Then, the valve opening control unit 511 calculates the pressure P1 which is a pressure anterior to each of air volume control units 40 by using the table T2 indicating a relation between the air volume and the pressure P1 which is a pressure anterior to air volume control units 40 (see FIG. 16B).

Then, the valve opening control unit 511 calculates the difference (pressure difference) between the pressure P1 anterior to air volume control units 40 and the stack pressure P2 (see FIG. 16B), and calculates the air resistance of air volume control units 40 from the pressure difference by using a given calculation formula. Then, the valve opening control unit 511 calculates the valve opening degree by referring to the table T3 indicating a relation between the air resistance of the air volume control unit 40 and the valve opening degree. The valve opening control unit 511 may calculate valve opening degrees of air volume control units 40 from the stack pressure, the external temperature and power consumption of each of servers by using the above algorithm. The two-dimensional tables T1 through T3 illustrated in FIG. 16A are preliminarily given by the experiment or the simulation.

The function of the fan control unit 512 is same as that described in FIG. 5. Thus the description will be omitted.

As described above, the valve opening control unit 511 may control valve opening degrees of air volume control units 40 so that temperatures inside servers 20 become the target temperature by using at least one of the given condition formula and the mathematical model based on power consumption of each of servers, the stack pressure and the external temperature. Accordingly, the control for reducing the power consumption may be performed by using obtainable other information even though it is difficult to obtain the temperature inside the server with the temperature sensor, the temperature measurement program or the like.

The above embodiment may be variable as described below.

### [First Variant Embodiment]

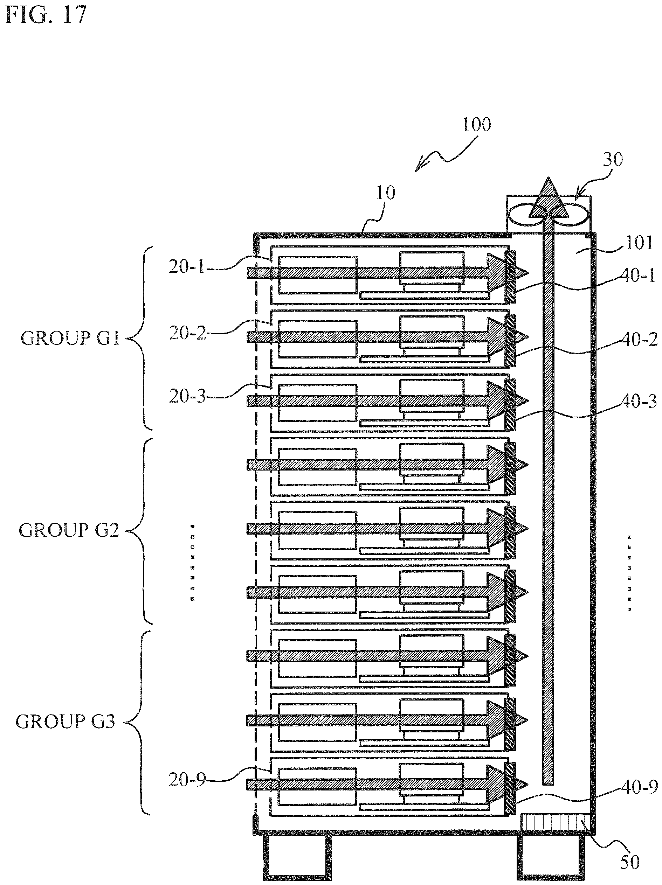

The first variant embodiment is a server device where each server is put in a group. A structure of a server device in accordance with the first variant embodiment is same as the server device in accordance with the first embodiment (FIG. 1). However, in the first variant embodiment, servers 20 are divided into three groups G1 through G3 as illustrated in FIG. 17. In the first variant embodiment, servers 20 are divided into three groups, but the number of groups is not limited to this embodiment. Moreover, in this embodiment, the number of servers 20 included in each group is three, but the number of servers included in each group is not limited to this embodiment and each group may have different number of servers. For example, it is possible to make groups so that the group G1 includes two servers, the group G2 includes two servers, and the group G3 includes five servers. It is possible to decide the composition of each group by calculating efficiency of compositions with a simulation and comparing them.

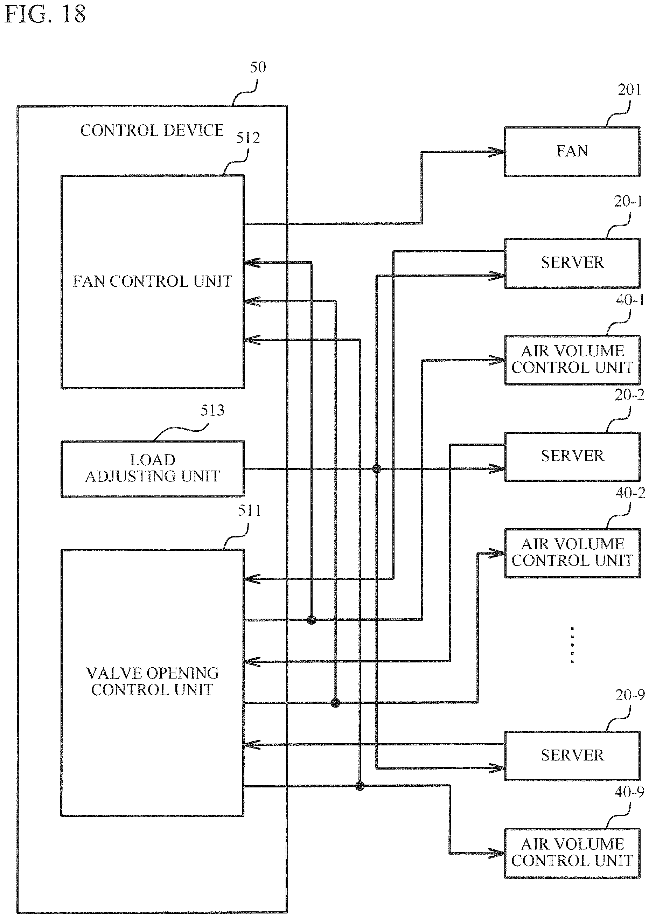

A description will now be given of a function of the control device in accordance with the first variant embodiment. FIG. 18 illustrates a functional block diagram of the control device in accordance with the first variant embodiment. The control device 50 includes a load adjusting unit 513 in addition to the valve opening control unit 511 and the fan control unit 512.

The load adjusting unit 513 distributes the processing requested to the server device 100 across groups, and adjusts the processing load shared by each group. That is to say that the load adjusting unit 513 regards each group as one information processing apparatus (virtualization). Moreover, the load adjusting unit 513 distributes a processing assigned to a group across servers included in a same group, and adjusts a processing load shared by each server. A detail process executed by the load adjusting unit 513 will be described in a second variant embodiment described later.

The load adjusting unit 513 distributes the processing across groups so that the ratio of processing loads of groups G1, G2 and G3 becomes 1 to 1 to 1, for example. Alternatively, the load adjusting unit 513 may distribute the processing across groups so that the ratio of processing loads of groups C1, G2 and G3 becomes 2 to 1 to 1, for example. In addition, the load adjusting unit 513 distributes the processing across servers so that the ratio of processing loads of servers 20-1, 20-2 and 20-3 included in the group G1 becomes 1 to 1 to 1.

The valve opening control unit 511 obtains temperatures inside servers from servers which are in the group. Then the valve opening control unit 511 calculates the valve opening degree to make the highest temperature of obtained temperatures inside servers become a target temperature. The valve opening control unit 511 controls air volume control units 40 so that all of the valve opening degrees of air volume control units 40 provided to servers included in the same group become the calculated valve opening degree. For example, assume that the temperature inside the server 20-2 is highest among temperatures inside servers 20-1 through 20-3 included in the group G1 for example. In this case, the valve opening control unit 511 calculates the valve opening degree to make the temperature inside the server 20-2 become a target temperature. When the calculated valve opening degree is 50% for example, the valve opening control unit 511 controls air volume control units 40-1∼40-3 respectively provided to servers 20-1 through 20-3 included in the group G1 so that valve opening degrees of servers 20-1 through 20-3 become 50%. The valve opening control unit 511 executes above process for each group.

As the process executed by the fan control unit 512 is same as that of the first embodiment, a description will be omitted.

### [Second Variant Embodiment]

In the first variant embodiment, air volume control units 40 are provided to servers. In a second variant embodiment, air volume control units 40 are provided to groups.

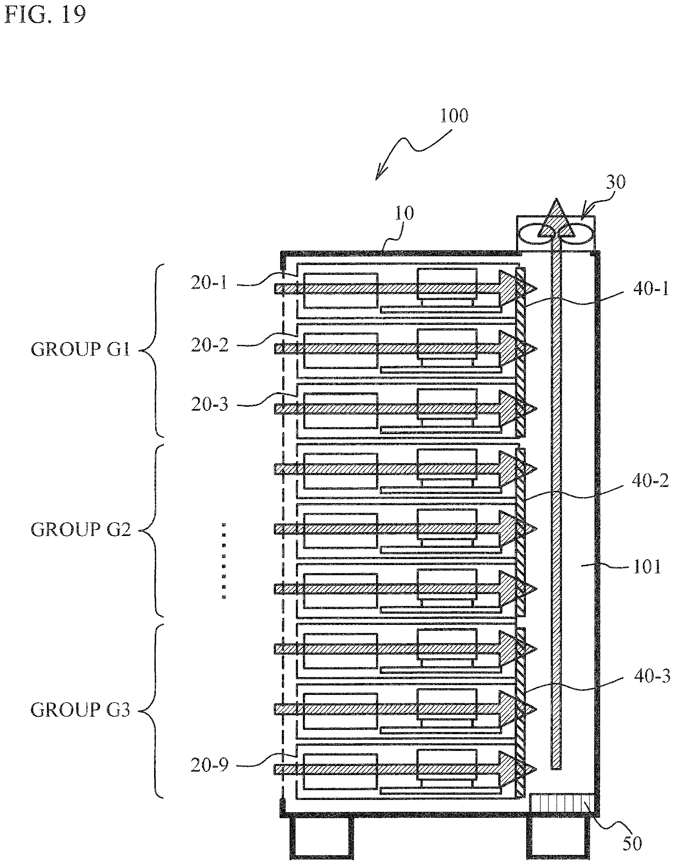

FIG. 19 illustrates a composition of a server device in accordance with the second variant embodiment. In the second variant embodiment, air volume control units 40-1 through 40-3 are provided to groups G1 through G3 respectively as illustrated in FIG. 19.

As functions of the control device in accordance with the second variant embodiment is almost same as those of the control device in accordance with the first variant embodiment, a description will be omitted. In the second variant embodiment, the valve opening control unit 511 calculates the valve opening degree to make the highest temperature of temperatures inside servers in the same group become a target temperature with respect to each group. Then the valve opening control unit 511 controls air volume control units 40 so that valve opening degrees of air volume control units 40 provided to groups become the calculated valve opening degrees.

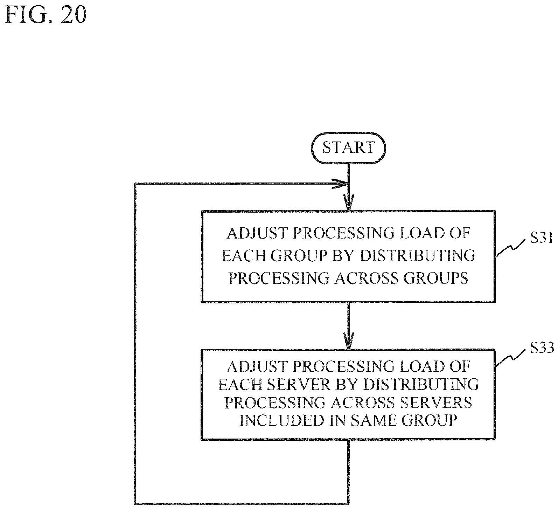

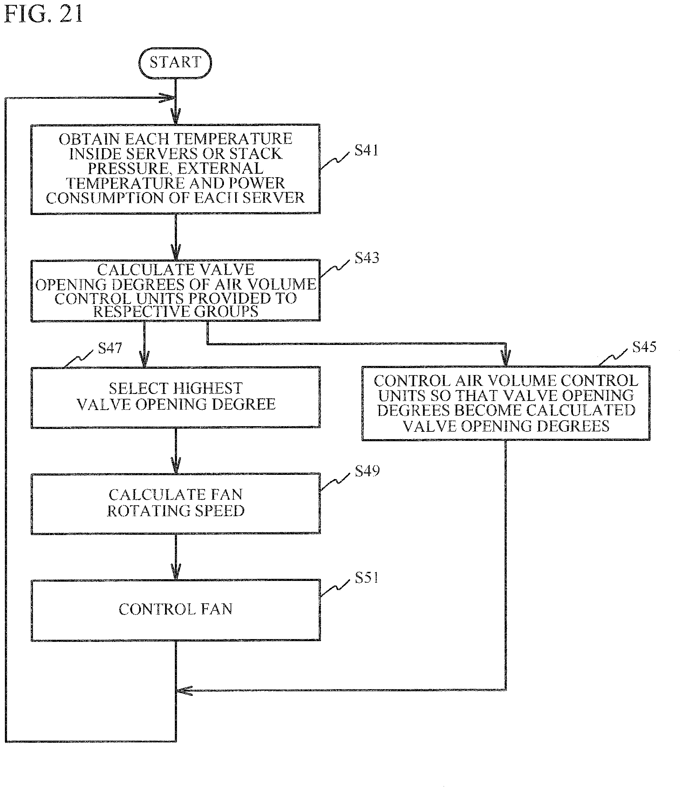

A description will now be given of a process executed by the control device in accordance with the second variant embodiment. FIG. 20 and FIG. 21 are flowcharts illustrating a process executed by the control device in accordance with the second variant embodiment.

Referring to FIG. 20, a description will be given of a process executed by the load adjusting unit 513. This process is common to the process executed by the load adjusting unit in accordance with the first variant embodiment. The load adjusting unit 513 distributes the processing across groups and adjusts the processing load shared by each group (step S31). Then, the load adjusting unit 513 distributes the processing across servers included in the same group, and adjusts the processing load shared by each server with respect to each group (step S33). The load adjusting unit 513 repeats procedures of steps S31 and S33.

A description will be given of a process executed by the valve opening control unit 511 and the fan control unit 512, with reference to FIG. 21. The valve opening control unit 511 obtains temperatures inside servers, or the stack pressure, the external temperature and power consumption of each of servers (step S41).

Then, the valve opening control unit 511 calculates valve opening degrees of air volume control units 40 provided to groups on the basis of the highest temperature inside the server or the highest power consumption in the group (step S43).

The valve opening control unit 511 controls air volume control units 40 so that valve opening degrees of air volume control units 40 become valve opening degrees calculated in the step S43 (step S45).

On the other hand, the fan control unit 512 selects the highest valve opening degree from valve opening degrees of air volume control units 40 calculated by the valve opening control unit 511 (step S47). The fan control unit 512 calculates the fan rotating speed to make the highest valve opening degree become the target opening degree (step S49). The fan control unit 512 controls the fan to rotate at the calculated rotating speed (step S51).

The valve opening control unit 511 and the fan control unit 512 repeat procedures of above steps step S41 through S51.

### [Third Variant Embodiment]

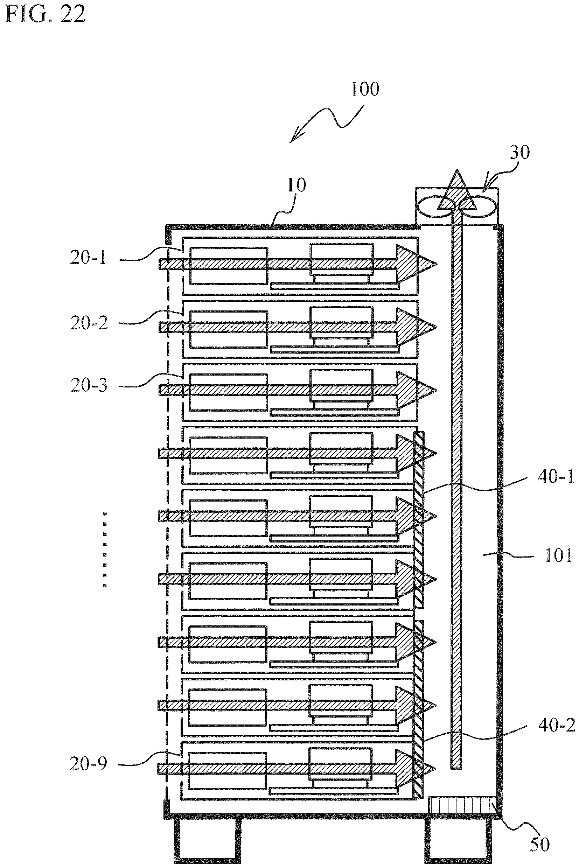

In the second variant embodiment, air volume control units 40 are provided to respective groups. In the third variant embodiment, the air volume control unit 40 is not provided to at least one group. FIG. 22 is a diagram illustrating a composition of the server device in accordance with the third variant embodiment. In FIG. 22, the air volume control unit 40 for group G1 is removed. In this embodiment, the air volume control unit 40 is not provided to the group G1, but the number of groups to which the air volume control unit 40 is not provided is not limited to one. The air volume control units 40 for groups other than the group G1 may be removed.

In the composition illustrated in FIG. 22, the load adjusting unit 513 distributes the processing across groups so that the processing load of a certain group is higher than those of other groups. In this case, the temperature inside the server included in the group of which the processing load is higher than those of other groups becomes highest. Therefore, the valve opening degree of the air volume control unit 40 provided to the group of which the processing load is higher than those of other groups becomes larger than the valve opening degree of air volume control units 40 provided to other groups. Thus, in the third variant embodiment, the air volume control unit 40 for the group of which the processing load is higher than those of other groups is removed, and the valve opening degree for the group becomes 100% all the time. For example, the load adjusting unit 513 adjusts the processing load of the group G1 to be higher than those of groups G2 and G3. In this case, the air volume control unit 40 is not provided to the group G1. The present composition is applicable to the first variant embodiment. For example, in the first variant embodiment, air volume control units 40-1 through 40-3 provided to servers 20-1 through 20-3 included in the group G1 may be removed.

A description will now be given of power consumption for cooling server devices in accordance with first through third variant embodiments. Power consumptions for cooling server devices in accordance with the first comparative example, the second comparative example, and first through third variant embodiments are calculated by the simulation. Mathematical models of the server and the server rack used for the simulation are models illustrated in FIG. 11 and FIG. 12.

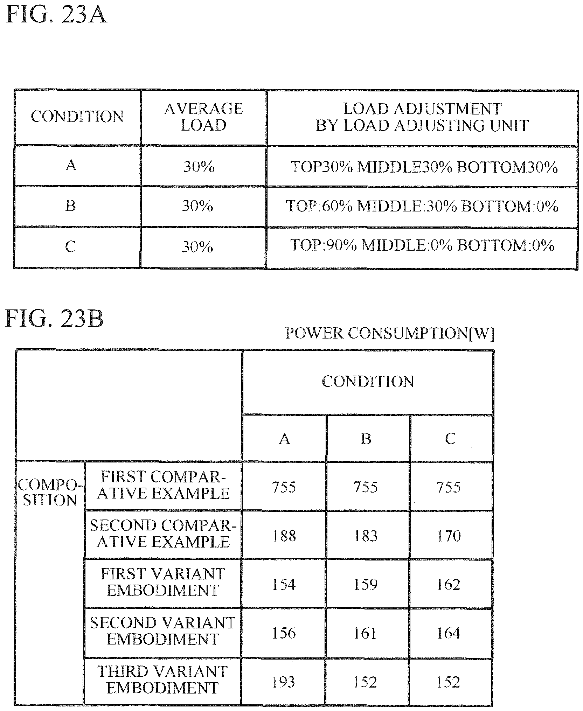

A description will be given, with reference to FIG. 23A, of conditions A through C used for the simulation. In each condition, the average load of the server device 100 is 30%. In the condition A, the processing load is adjusted by the load adjusting unit 513 so that processing loads of groups G1, G2 and G3 become 30%.

In the condition B, the processing load is adjusted by the load adjusting unit 513 so that the processing load of the group G1 becomes 60%, that of the group G2 becomes 30%, and that of the group G3 becomes 0%.

In the condition C, the processing load is adjusted by the load adjusting unit 513 so that the processing load of the group G1 becomes 90%, those of groups G2 and G3 becomes 0%.

Simulation results are indicated in FIG. 23B. In each case, the power consumption of the server device in accordance with the first variant embodiment is lower than the server device in accordance with the second comparative example (FIG. 8: the server device where the control of the valve opening degrees and the control of the fan rotating speed are performed independently). Moreover, there is a case that the power consumption is reduced more depending on the ratio of respective processing loads that groups share, compared to the power consumption of the first embodiment illustrated in FIG. 13.

As seen in above description, according to the first variant embodiment, the load adjusting unit 513 adjusts the load that each group, which is made by dividing servers 20, shares, and the load of servers 20 included in each group. The valve opening control unit 511 makes valve opening degrees of air volume control units 40, which are provided to servers in the same group, become an identical valve opening degree, when air volume control units 40 are provided to servers. According to this, as the load may be distributed across groups by the load adjusting unit 513 so that the cooling efficiency becomes highest.

According to the second variant embodiment, the load adjusting unit 513 adjusts the load shared by each group defined by dividing servers 20, and air volume control units 40 are provided to groups. According to this, it becomes possible to reduce the power consumption, to reduce the production cost of the server device 100 and to improve fault-tolerance of the air volume control unit 40 because the number of air volume control units 40 may be reduced.

According to the third variant embodiment, the air volume control unit 40 is not provided to at least one group of which the load is set to be higher than those of other groups. According to this, it becomes possible to reduce the power consumption, to reduce the production cost of the server device 100 and to improve fault-tolerance of the air volume control unit 40 because the number of air volume control units 40 may be further reduced.

In first through third variant embodiment described above, the load adjusting unit 513 may adjust the processing load shared by each group so that the processing load of either group becomes 0% (no load), and powers off servers 20 included in the group of which the processing load becomes 0%. According to this, as it becomes unnecessary to cool the server of which the processing load becomes 0%, the power consumption may be further reduced. This is applicable to the first embodiment.

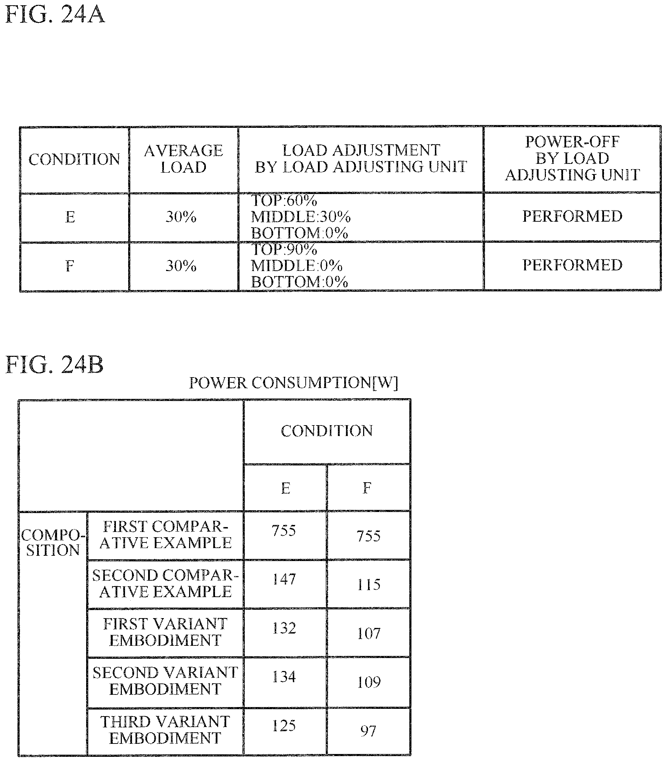

Here, a description will be given of the simulation result of the power consumption for cooling the server device 100 when servers 20 included in the group of which the processing load becomes 0% are powered off. FIGs. 24A and 24B are a simulation result of the power consumption for cooling the server device when the server of which the load becomes 0% is powered off.

In FIG. 24A, as the condition E, the processing load is adjusted so that the group G1 shares 60% of the load, the group G2 shares 30% of the load, and the group G3 shares 0% of the load, and servers included in the group G3 of which the load becomes 0% are powered off. As the condition F, the load adjusting unit 513 adjusts the load so that the group G1 shares 90% of the load, and groups G2 and G3 share 0% of the load, and servers included in groups G2 and G3 of which the load becomes 0% are powered off.

As seen in FIG. 24B, when comparing the power consumption under the condition B indicated in FIG. 23B with that under the condition E, the power consumption under the condition E is less than that under the condition B. When comparing the power consumption under the condition C indicated in FIG. 23B with that under the condition F, the power consumption under the condition F is less than that under the condition C. As seen in the above description, the load adjusting unit 513 powers off servers included in the group of which the load becomes 0%, and it becomes unnecessary to cool servers 20 which are powered off. According to this, the power consumption for cooling the server device 100 may be further reduced.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment of the present invention has been described in detail, it should be understood that the various change, substitutions, and alterations could be made hereto without departing from the spirit and scope of the invention.

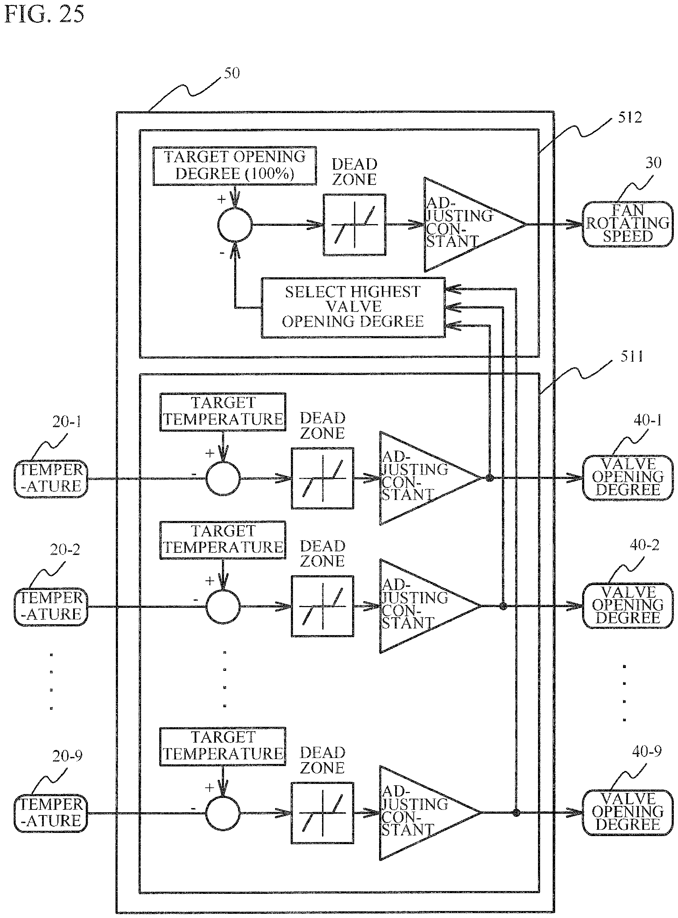

For example, in the first embodiment and first through third variant embodiments, as illustrated in FIG. 25, a dead zone may be provided when the valve opening degree and the fan rotating speed are calculated. This suppresses the continual movement of the shutter 402, and enables to reduce the power consumption for driving the shutter 402, and prevent the break of air volume control units 40 caused by abrasion or the like. In addition, when the state where the valve opening degree does not change continues for a given period of time, the valve opening control unit 511 may power off the drive mechanism 403 that drives the shutter 402. This enables to further reduce the power consumption for cooling the server device 100.

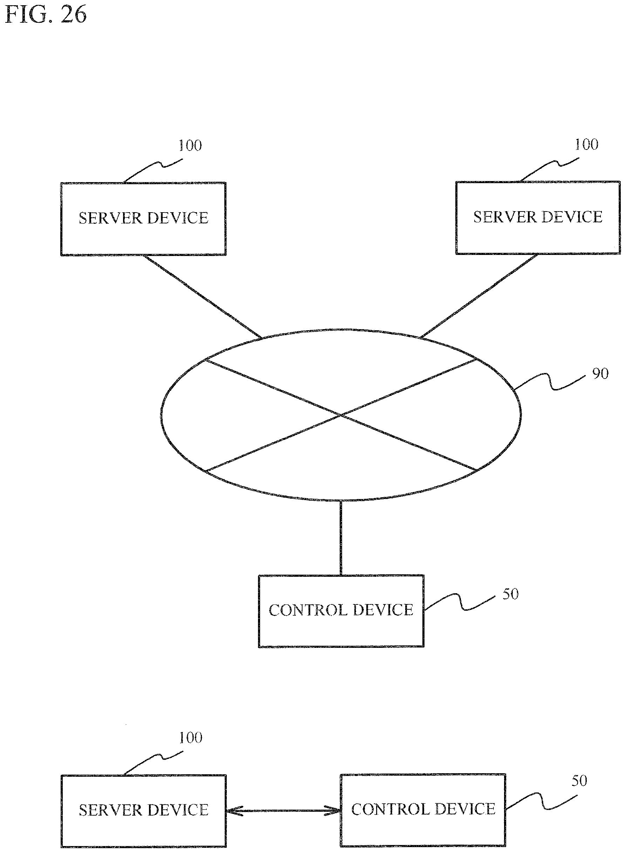

In above embodiments, the control device 50 is provided to the server rack 10, but may be coupled to the server device 100 via a network as illustrated in FIG. 26A. In this case, the control device 50 transmits the control signal to the server device 100 via the network 90, and controls respective valve opening degrees of air volume control units 40 and the rotating speed of the fan 30. In addition, the control device 50 may control multiple server devices 100. Moreover, the server device 100 may be directly coupled to the control device 50 by the cable or the like (FIG. 26B).

The control functions described above may be achieved by a computer. In that case, cooling control programs where the process of the function that the control device 50 has is written are provided. The control function described above may be implemented by the computer by executing the cooling control programs by the computer. Programs where the process is written may be stored in the non-transitory computer readable medium.

When programs are distributed in a non-transitory transportable recording medium such as DVDs (Digital Versatile Disc) and CD-ROMs (Compact Disc Read Only Memory) in which programs are recorded. Programs may be stored in a storage device of a server computer, and be transferred to other computers from the server computer via a network.

The computer executing programs store programs recoded in the transportable recoding medium or programs transferred from the server computer to its storage device. Then, the computer reads a program from its storage device, and executes the process according to the program. The computer reads a program from the transportable recording medium directly and executes the process according to the transportable recording medium directly and executes the process according to the program. The computer executes a process according to a program that the computer receives every time when the program is transferred from the server computer.

In any of the above aspects, the various features may be implemented in hardware, or as software modules running on one or more processors. Features of one aspect may be applied to any of the other aspects.

The invention also provides a computer program or a computer program product for carrying out any of the methods described herein, and a computer readable medium having stored thereon a program for carrying out any of the methods described herein. A computer program embodying the invention may be stored on a computer-readable medium, or it could, for example, be in the form of a signal such as a downloadable data signal provided from an Internet website, or it could be in any other form.

The computer readable medium could be a non-transitory computer readable medium.

## Claims

1. A server device comprising:
electronic devices;
a housing that houses the electronic devices;
at least one fan;
air volume control units configured to adjust a volume of cooling airflow which is generated by rotation of the at least one fan and is ventilated through the electronic devices by opening and closing of respective valves;
a valve opening control unit configured to control valve opening degrees of the air volume control units so that temperatures inside the electronic devices become a given target temperature;
a fan control unit configured to run the at least one fan at a fan rotating speed that achieves a volume of cooling airflow to make temperatures inside the electronic devices become the given target temperature at a valve opening degree higher than the valve opening degrees that the valve opening control unit controls.

2. The server device according to claim 1, further comprising
a load adjusting unit configured to adjust a load shared by each group defined by grouping the electronic devices,
wherein each group is provided with at least one of the air volume control units, optionally except a particular group that handles a load higher than loads of other groups.

3. The server device according to claim 1 or 2, further comprising
a load adjusting unit configured to adjust a load shared by each group defined by grouping the electronic devices, and a load of each electronic device included in a same group,
wherein each of electronic devices is provided with at least one of the air volume control units, and
the valve opening control unit sets the air volume control units that belongs to the electronic devices in a same group to an identical valve opening degree.

4. The server device according to claim 2 or 3, wherein the load adjusting unit adjusts a load shared with each group so that at least one group has no load, and powers off the electronic devices included in the at least one group.

5. The server device according to any of claims 1 through 4, wherein the valve opening control unit powers off a drive mechanism that drives a valve of one of the air volume control units when the one of the air volume control units has an identical valve opening degree for more than a given period of time.

6. The server device according to any of claims 1 through 5, wherein the valve opening control unit controls the valve opening degrees of the air volume control units so that temperatures inside the electronic devices become the given target temperature by using at least one of a given condition formula and a given mathematical model based on power consumption of each the electronic devices, stack pressure indicating a strength of injection or ejection of air by the at least one fan, and an external temperature indicating a temperature outside of the housing.

7. A control device that controls at least one fan that generates cooling airflow inside electronic devices housed in a housing and air volume control units configured to adjust a volume of cooling airflow by opening and closing of respective valves, the control device comprising:
a valve opening control unit configured to control valve opening degrees of the air volume control units so that temperatures inside the electronic devices become a given target temperature;
a fan control unit configured to run the at least one fan at a fan rotating speed that achieves a volume of cooling airflow to make temperatures inside of the electronic devices become the given target temperature at a valve opening degree higher than the valve opening degrees that the valve opening control unit controls.

8. The control device according to claim 7, further comprising
a load adjusting unit configured to adjust a load shared by each group defined by grouping the electronic devices,
wherein each group is provided with at least one of the air volume control units, optionally except a particular group that handles a load higher than loads of other groups.

9. The control device according to claim 7 or 8, further comprising
a load adjusting unit configured to adjust a load shared by each group defined by grouping the electronic devices, and a load of each electronic device included in a same group,
wherein each of the electronic devices is provided with at least one of the air volume control units, and
the valve opening control unit sets the air volume control units that belong to the electronic devices in a same group to an identical valve opening degree.

10. The control device according to claim 8 or 9, wherein the load adjusting unit adjusts a load shared with each group so that at least one group has no load, and powers off the electronic devices included in the at least one group.

11. The control device according to any of claims 7 through 10, wherein the valve opening control unit powers off a drive mechanism that drives a valve of one of the air volume control units when the one of the air volume control units has an identical valve opening degree for more than a given period of time.

12. The control device according to any of claims 7 through 11, wherein the valve opening control unit controls the valve opening degrees of the air volume control units so that temperatures inside the electronic devices become the given target temperature by using at least one of a given condition formula and a given mathematical model based on power consumption of each of the electronic devices, stack pressure indicating a strength of injection or ejection of air by the at least one fan, and an external temperature indicating a temperature outside of the housing.

13. A server rack that houses electronic devices, the server rack comprising:
at least one fan; and
a control device,
the control device including:
a valve opening control unit configured to control valve opening degrees of air volume control units configured to adjust a volume of cooling airflow which is generated by rotation of the at least one fan and is ventilated through the electronic devices by opening and closing of respective valves so that temperatures inside the electronic devices become a given target temperature; and
a fan control unit configures to run the at least one fan at a fan rotating speed that achieves a volume of cooling airflow to make temperatures inside of the electronic devices become the given target temperature at a valve opening degree higher than the valve opening degrees that the valve opening control unit controls.

14. A computer program for causing a computer to execute a procedure for cooling a server device including electronic devices and a housing that houses the electronic devices, the procedure comprising:
controlling valve opening degrees of air volume control units configured to adjust a volume of cooling airflow which is generated by rotation of at least one fan provided to the housing and is ventilated through the electronic devices by opening and closing of respective valves so that temperatures inside the electronic devices become a given target temperature; and
running the at least one fan at a fan rotating speed that achieves a volume of cooling airflow to make temperatures inside of the electronic devices become the given target temperature at a valve opening degree higher than the valve opening degrees that the valve opening control unit controls.

15. A control method for cooling a server device including electronic devices and a housing that houses the electronic devices, the control method comprising:
controlling valve opening degrees of air volume control units configured to adjust a volume of cooling airflow which is generated by rotation of at least one fan provided to the housing and is ventilated through the electronic devices by opening and closing of respective valves so that temperatures inside the electronic devices become a given target temperature; and
running the at least one fan at a fan rotating speed that achieves a volume of cooling airflow to make temperatures inside of the electronic devices become the given target temperature at a valve opening degree higher than the valve opening degrees that the valve opening control unit controls.
